# EUROPÄISCHE PATENTSCHRIFT

(11) **EP 1 603 773 B1**
(45) Veröffentlichungstag und Bekanntmachung des Hinweises auf die Patenterteilung: **21.11.2007**
(21) Anmeldenummer: 04721871.4
(22) Anmeldetag: 19.03.2004
(51) Int. Cl.: B60R 16/02, H02J 7/14, G01R 31/36

(54) **VERFAHREN UND SYSTEM ZUR FRÜHERKENNUNG EINES AUSFALLES EINES ELEKTRISCH GESTEUERTEN BREMSSYSTEMS**
METHOD AND SYSTEM FOR EARLY DETECTING THE DEFECTS OF AN ELECTRICALLY CONTROLLED BRAKE SYSTEM
PROCEDE ET SYSTEME DE DETECTION PRECOCE D'UN DYSFONCTIONNEMENT D'UN SYSTEME DE FREINAGE A COMMANDE ELECTRIQUE

(30) Priorität: 20.03.2003 DE 10312481
(43) Veröffentlichungstag der Anmeldung: 14.12.2005
(73) Patentinhaber: Lucas Automotive GmbH, 56070 Koblenz (DE)
(72) Erfinder: SCHEIDER, Werner, 56729 Monreal (DE)
(74) Vertreter: Röthinger, Rainer
(86) Internationale Anmeldenummer: PCT/EP2004/002905
(87) Internationale Veröffentlichungsnummer: WO 2004/083000

(56) Entgegenhaltungen:
- EP-A- 0 800 955
- WO-A-02/25794
- DE-A- 10 049 495
- DE-A- 10 150 381

## Beschreibung

### Gebiet der Erfindung

Die Erfindung betrifft die zur Früherkennung eines möglichen Ausfalles eines elektrisch gesteuerten Bremssystems durchgeführte Überprüfung einer von einer Fahrzeugbatterie bereitgestellten Bordnetzspannung.

### Hintergrund der Erfindung

Zur Feststellung von Fehlfunktionen oder möglichen Ausfällen von Fahrzeugkomponenten wie einer Fahrzeugbatterie sind verschiedene Verfahren bekannt. Bei der Fahrzeugbatterie handelt es sich um eine besonders kritische Ausfallkomponente, da die Lebensdauer einer Batterie in der Regel kürzer ist als ein Fahrzeugleben. Dies hat zur Folge, dass eine Fahrzeugbatterie pro Fahrzeug ca. dreimal getauscht werden muss.

Bei einem Ausfall der Fahrzeugbatterie ist eine Spannungsversorgung des Bordnetzes nicht mehr zuverlässig gewährleistet, da auch bei Fahrten im unteren Drehzahlbereich, wie zum Beispiel bei Stadtfahrten, die Ladeleistung der Lichtmaschine nicht immer zum vollständigen Wiederaufladen der Fahrzeugbatterie und Erreichen der Maximalspannung ausreicht. Eine zweite Batterie zum Aufrechterhalten der Spannungsversorgung wird jedoch aus Kostengründen von den meisten Fahrzeugherstellern abgelehnt. Da eine der strengsten Sicherheitsanforderungen besagt, dass für elektrisch gesteuerte Bremssysteme wie z.B. elektrische Parkbremsen eine ausreichende und ununterbrochene Bordnetzspannung gewährleistet sein muss, ist eine permanente Überwachung des Ladezustandes der Fahrzeugbatterie unbedingt notwendig.

Aus der DE 198 45 562 C1 sind ein Verfahren und eine Vorrichtung zur Ermittlung des Bordnetzzustandes eines Kraftfahrzeuges bekannt. Dort wird ein gefilterter oder zeitlich gemittelter Spannungswert zur Überprüfung des Bordnetzzustandes verwendet. Dazu wird eine spezielle Auswerteeinrichtung eingesetzt.

Ein weiteres Verfahren und eine Vorrichtung zur Ermittlung des Bordnetzzustandes sind aus der DE 198 45 565 C1 bekannt. Bei diesem Verfahren werden durch Kurzzeitverbraucher verursachte Spannungseinbrüche bei einer Beurteilung der Bordnetzspannung aus Acht gelassen, indem eingeschaltete Kurzzeitverbraucher an eine Spannungsüberwachungseinrichtung mitgeteilt werden, damit die durch diese Kurzzeitverbraucher hervorgerufene Spannungseinbrüche bei der Bewertung der Bordnetzspannung unbeachtet bleiben.

In der DE 198 45 561 C2 wird ein Verfahren zur Fehlererkennung in einem Kraftfahrzeugbordnetz beschrieben, bei dem die Bordnetzspannung mit einer Sollspannung verglichen, wird und bei einer Abweichung in einer speziell dafür ausgelegten Fehlererkennungseinrichtung festgestellt wird, ob ein Generator-Lastsignal von einem zugehörigen Wert abweicht.

Die EP 0 800 955 A2 zeigt eine Energieversorgungsvorrichtung für Fahrzeuge, welche einen Verbraucherstrom berechnet, der von einer Lasteinheit verbraucht wird. Die Energieversorgungseinrichtung vergleicht den berechneten Verbraucherstrom mit einem Anschlussstrom, der von einer Batterie zugeführt wird, und unterbricht die Zuführung des Anschlussstroms, wenn der Anschlussstrom außergewöhnlich groß ist.

Bei dem in der gattungsbildenden DE 100 49 495 A1 beschriebenen Verfahren zur Bestimmung der Gebrauchsfähigkeit eines Akkumulators in einem Kraftfahrzeug wird nach Beginn des Starts die Spannung U_{SE} bestimmt, bei welcher der größte Spannungseinbruch erfolgt. Eine zeitlich darauf folgende Spannung U₀₀ wird zu dem Zeitpunkt bestimmt, bei dem der direkt folgende Nulldurchgang des durch den Akkumulator fließenden Stroms stattfindet. Anschließend wird der Innenwiderstand des Akkumulators als Maß für seine Gebrauchsfähigkeit aus der Spannungsdifferenz zwischen U₀₀ und U_{SE} und einem empirisch ermittelten Zusammenhang zwischen Motortemperatur und Leistungsaufnahme des Startermotors ermittelt.

In der WP 02/25794 wird ein Verfahren zur Regelung eines Generators in einem Kraftfahrzeug mit mindestens einer Batterie beschrieben, bei dem in Abhängigkeit von vorgegebenen Umschaltbedingungen zwischen einem Rekuperationsbereitschaftsmodus und einem Erholungsmodus umgeschaltet wird, wobei im Erholungsmodus eine Sollwertspannung so vorgegeben wird, dass sich die Batterie regeneriert.

Der Erfindung liegt die Aufgabe zugrunde, ein einfaches Verfahren sowie-ein System zur Früherkennung eines möglichen Ausfalles eines elektrisch gesteuerten Bremssystems zu schaffen.

### Kurze Beschreibung der Erfindung

Diese Aufgabe wird erfindungsgemäß durch ein Verfahren gemäß Anspruch 1 und ein System gemäß Anspruch 12 gelöst. Weitere Ausgestaltungen der Erfindung sind in den Unteransprüchen 2 bis 11 enthalten.

Das Ergebnis der Überprüfung wird zur Früherkennung eines möglichen Ausfalles eines elektrisch gesteuerten Bremssystems, z.B. einer elektrischen Parkbremse (EPB) oder einer elektrohydraulischen oder elektromechanischen Bremsanlage (EHB, EMB) verwendet.

Mit dem erfindungsgemäßen Verfahren wird erreicht, dass bei Erkennen eines kritischen Zustandes der Fahrzeugbatterie entsprechende Maßnahmen getroffen werden können und z.B. rechtzeitig ein Austausch der Fahrzeugbatterie veranlasst werden kann und/oder eine zweite Fahrzeugbatterie aktiviert wird.

In einem mit einem elektrisch gesteuerten Bremssystem ausgerüsteten fahrzeug können verschiedene Steuergeräte über einen im Fahrzeug installierten Bus, vorzugsweise über einen CAN-Bus, miteinander vernetzt sein, die über diesen miteinander kommunizieren können. Alternativ können diese Steuergeräte aber auch über eine, drahtlose Verbindung, beispielsweise über Bluetooth, miteinander Informationen austauschen.

Zum Überprüfen der Bordnetzspannung wird eine elektrische Last durch ein dieser Last zugeordnetes erstes Steuergerät eingeschaltet. Bei dieser Last kann es sich z.B. um eine Klimaanlage oder eine beheizbare Heckscheibe handeln, jedoch ist auch die Verwendung anderer elektrischer, vorzugsweise niederohmiger und standardmäßig vorgesehener Lasten im Kraftfahrzeug möglich.

Die Last wird auf Befehl von dem dieser Last zugeordneten Steuergerät vorzugsweise kurzfristig eingeschaltet, ohne dass dies für den Fahrzeugführer erkennbar sein muss. Wenn als elektrische Last z.B. eine Klimaanlage eingeschaltet wird, dann handelt es sich bei dem ersten Steuergerät um das Steuergerät der Klimaanlage (Klima-ECU). Wird als elektrische Last die Heckscheibenheizung verwendet, wird das hierfür zugeordnete Steuergerät zum Einschalten benutzt, jedoch können auch anderweitige Vorrichtungen im Fahrzeug durch den diesen zugeordneten Steuergeräte aktiviert werden wie z.B. das Navigationssystem oder eine elektrische Sitzverstellung des Beifahrersitzes.

Im eingeschalteten Zustand der Last erfolgt mittels eines zweiten Steuergerätes eine Überprüfung der Fahrzeugbatterie. Bei diesem zweiten Steuergerät handelt es sich vorzugsweise um das elektronische Steuergerät des elektrisch gesteuerten Bremssystems, also z.B. das Steuergerät der elektrischen Parkbremse (EPB-ECU). Dieses zweite Steuergerät überprüft die Fahrzeugbatterie, um feststellen zu können, ob aufgrund einer Veränderung der Batteriekapazität die Gefahr eines Ausfalles der elektrischen Parkbremse besteht.

Bei dem Ergebnis der Überprüfung handelt es sich vorzugsweise um den gemessenen Bordnetzspannungswert, der von dem zweiten Steuergerät über einen Fahrzeugbus einem dritten Steuergerät zur Information des Fahrzeugsführers zur Verfügung gestellt werden kann. Bei diesem dritten Steuergerät handelt es sich vorzugsweise um ein Steuergerät für das Armaturenbrett (Kombi-ECU), jedoch wäre auch die Weitergabe der Information an das Navigationssystem oder andere im Fahrzeug installierte, über den Fahrzeug-Bus erreichbare und mit dem Fahrzeugführer über einen Kommunikationskanal in Kontakt stehende Steuergeräte mit ihren zugeordneten Vorrichtungen möglich.

Das Ergebnis der Überprüfung kann einem Fahrzeugführer als Information durch das dritte Steuergerät mitgeteilt werden. Dies kann mittels eines optischen Signals, das z.B. im Armaturenbrett angezeigt wird, vorzugsweise als LED-Anzeige oder eine Anzeige in Klartext, erfolgen. Wird zwischen einer korrekten Funktion und einem fehlerhaften Verhalten unterschieden, wäre auch eine farbliche Unterscheidung möglich. Ebenso ist ein akustisches Signal denkbar. Das Anzeigen erfolgt vorzugsweise auch im laufenden Betrieb des Kraftfahrzeugs. Da der Informationsaustausch zweckmäßigerweise über den im Fahrzeug vorhandenen CAN-Bus erfolgt, ist ebenso ein weiteres Verarbeiten der erhaltenen Information möglich sowie eine Rückkopplung mit dem Hinweis, weitere Messungen vorzunehmen, für die Messung auf andere Lasten auszuweichen und mit weiteren (z.B. zyklischen) Messungen fortzufahren.

Die Überprüfung des Zustandes der Fahrzeugbatterie kann mit Hilfe zyklischer Messungen vorgenommen werden, wobei es sich bei den zyklischen Messungen um Messungen in einem vordefinierten oder veränderlichen Zeitabstand handeln kann. Zeitpunkte für die Messung können in Abhängigkeit von einer aktuellen Batteriekapazität gewählt werden. Die Messungen können im Sekundentakt, im Minutentakt und bevorzugt auch bei abgeschalteter Zündung erfolgen. Denkbar wäre auch, einen anderen Zeitabstand zu wählen oder eine Abhängigkeit von der durchschnittlichen Fahrleistung/-zeit herzustellen.

Aufgrund der mittels der zyklischen Messungen erzielten Messergebnisse kann eine vordefinierte Maßnahme eingeleitet werden, jedoch können auch mehrere, vorzugsweise gleichzeitige Maßnahmen durchgeführt werden. Bei einer dieser Maßnahmen kann es sich z.B. um eine Fahrzeugführerwamung vor Eintreten eines kritischen Zustandes handeln.

Weitere Maßnahmen können das Abschalten von diversen Stromverbrauchern wie zum Beispiel der Klimaanlage oder einer Sitzheizung sein. Jedoch ist auch ein Abschalten aller nicht sicherheitsrelevanten Stromverbraucher möglich. Es wäre denkbar, diese Maßnahme nur bei abgeschalteter Zündung durchzuführen.

Zweckmäßigerweise sollten im Fahrzeug die Stromverbraucher in sicherheitsrelevante und nicht sicherheitsrelevante Stromverbraucher eingeteilt sein, wobei verschiedene Reihenfolgen für das Abschalten von nicht sicherheitsrelevanten Stromverbrauchern oder eine Einteilung je nach Stromverbrauch existieren können. Unter Umständen ist es auch denkbar, unterschiedliche Jahreszeiten und Tages-/Nachtzeiten zu berücksichtigen, da diverse Stromverbraucher im Winter eine andere sicherheitsrelevante Funktion haben als im Sommer. Eine Klimaanlage kann im Winter unbedingt notwendig sein, um eine vollständige Sicht durch die Frontscheibe zu gewährleisten, wohingegen es sich im Sommer bei der Heckscheibenheizung oder der Sitzheizung um weniger sicherheitsrelevante Fahrzeugkomponenten handelt.

### Kurze Beschreibung der Zeichnungen

Weitere Vorteile und Ausgestaltungen der Erfindung ergeben sich aus der nachfolgenden Beschreibung des bevorzugten Ausführungsbeispiels und den Figuren. Es zeigen:
- Fig. 1: ein vereinfachtes Blockschaltbild einer Vorrichtung zur Durchführung des erfindungsgemäßen Verfahrens;
- Fig. 2: ein ausführlicheres Blockschaltbild einer bevorzugten Ausführungsform des erfindungsgemäßen Verfahrens; und
- Fig. 3: ein Anwendungsbeispiel für zyklische Messungen und daraus resultierende Maßnahmen.

### Beschreibung eines bevorzugten Ausführungsbeispiels

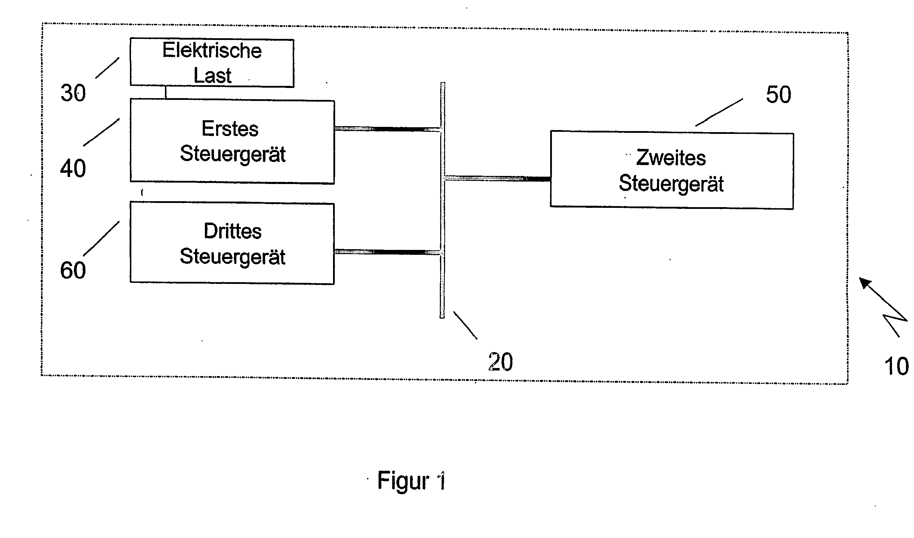

Das in Fig. 1 dargestellte Blockschaltbild zeigt schematisch das Zusammenwirken der verschiedenen Steuergeräte in einem mit einem elektrisch gesteuerten Bremssystem in Gestalt einer EPB ausgerüsteten Fahrzeug 10 mittels der Kommunikation über einen vorhandenen CAN-Bus 20. Für die Ausfall-Früherkennung werden die über den CAN-Bus 20 miteinander vernetzten, bereits vorhandenen Steuergeräte eingesetzt. Bei dem erfindungsgemäßen Verfahren werden eine elektrische Last 30 und das ihr zugeordnete erste Steuergerät 40 sowie ein zweites Steuergerät 50, das über den CAN-Bus 20 mit einem dritten Steuergerät 60 kommuniziert, verwendet.

Im Rahmen der Früherkennung eines EPB- Ausfalls wird die elektrische Last 30, ein Stromverbraucher im Fahrzeug, durch das ihr zugeordnete erste Steuergerät 40 eingeschaltet. Das zweite Steuergerät 50 überprüft während der eingeschalteten elektrischen Last die Bordnetzspannung U_{Bat} und liefert über den CAN-Bus 20 das Ergebnis der Überprüfung an ein drittes Steuergerät 60. Das dritte Steuergerät verarbeitet das Meßergebnis und veranlasst weitergehende Maßnahmen.

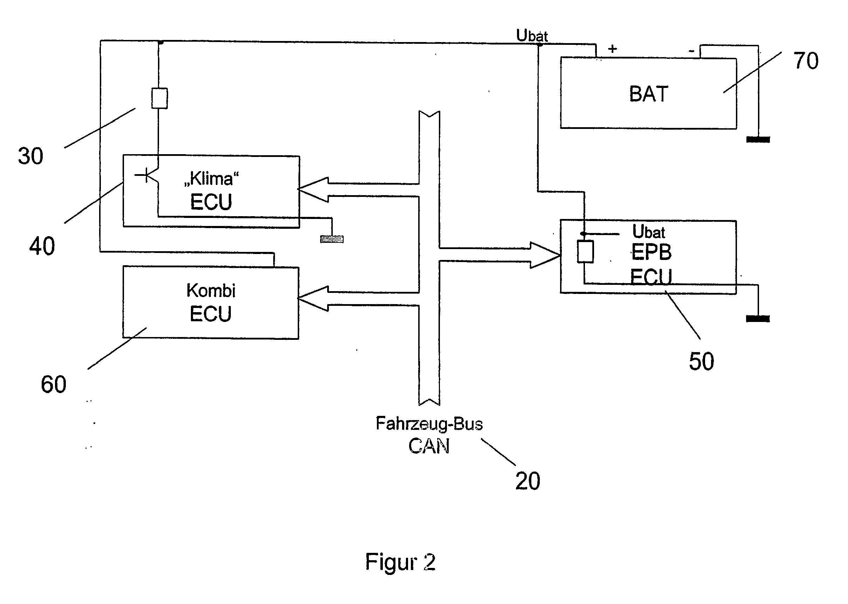

Fig. 2 zeigt ein bevorzugtes Ausführungsbeispiel der erfindungsgemäßen Vorrichtung. Hierbei wird als elektrische Last 30 eine Klimaanlage eingesetzt mit dem ihr zugeordneten Steuergerät, der Klima-ECU 40. Als zweites Steuergerät wird das Steuergerät der elektrischen Parkbremse EPB-ECU 50 verwendet, das über den CAN-Bus 20 mit dem dritten Steuergerät 60, der Kombi-ECU, Informationen austauscht.

In einem ersten Schritt zur Ausfall-Früherkennung wird eine Klimaanlage durch deren Steuergerät Klima-ECU 40 eingeschaltet. Während die Klimaanlage eingeschaltet ist, wird das Steuergerät der elektrischen Parkbremse EPB-ECU 50 angewiesen, an der Fahrzeugbatterie 70 die aktuelle Bordnetzspannung U_{Bat} zu überprüfen. Es stellt über den CAN-Bus 20 das Ergebnis der Messung dem dritten Steuergerät 60, der Kombi-ECU, zur Weiterverarbeitung und zur Durchführung von Maßnahmen zur Verfügung. Eine mögliche Maßnahme ist, dass der Fahrzeugführer eine Information erhält und dadurch rechtzeitig einen Austausch der Fahrzeugbatterie 70 veranlassen kann.

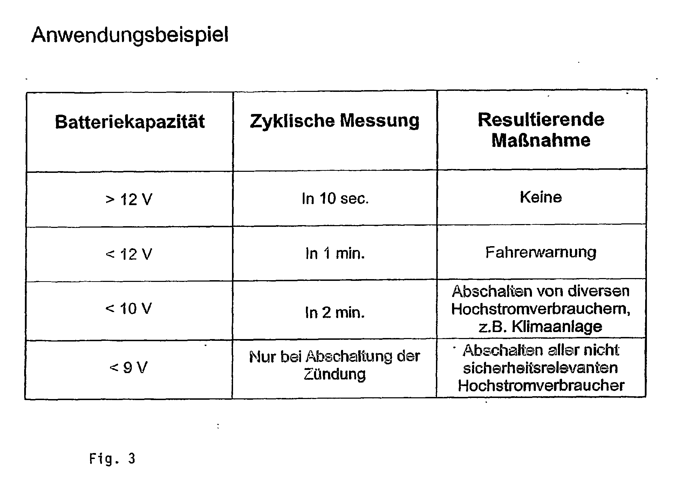

Ein Ausführungsbeispiel für die Definition von Zyklen für die Messungen und das Einleiten daraus resultierender Maßnahmen ist in Fig. 3 gezeigt. Um einen Ausfall der elektrischen Parkbremse aufgrund zu geringer Bordnetzspannung zu verhindern, werden im vorliegenden Ausführungsbeispiel verschiedene Zyklen für die Messungen vorgeschlagen. Von den gemessenen Spannungswerten abhängig, werden unterschiedliche Messungen durchgeführt. Es wurde eine Einteilung in mehr als 12 V, zwischen 10 und 12 V, weniger als 10 V, jedoch mehr als 9 V, und weniger als 9 V vorgenommen. Daraus folgend ergibt sich der Zeitraum für den Abstand der Messungen, die im einzelnen der Fig. 3 entnommen werden können, sowie die daraus resultierenden Maßnahmen.

Wie aus Fig. 3 erkennbar ist, wird bei einer hohen Batteriekapazität, also mehr als z.B.12 V, eine zyklische Messung im 10-Sekunden-Takt durchgeführt. Eine resultierende Maßnahme wie eine Information des Fahrzeugführers ergibt sich hieraus nicht, da dies bei einer vollständigen Batteriekapazität von mehr als 12 V als vorauszusetzender Normalzustand angesehen wird.

Sinkt die Batteriekapazität unter 12 V ab, unterschreitet jedoch nicht den Spannungswert von 10 V, erfolgt eine zyklische Messung im Minutenabstand. Beim Sinken der Bordnetzspannung unterhalb der normalen Batteriekapazität bis zu 10 V erfolgt ein z.B. optisches Informieren des Fahrers.

Beträgt der Bordnetzspannungswert zwischen 9 und 10 V, wird der Zeitabstand der zyklischen Messung zur Reduzierung des Stromverbrauchs z.B. auf zwei Minuten erhöht und es erfolgt eine erste. Vorsichtsmaßnahme, um die Fahrzeugbatterie nicht unnötig zu belasten und damit die Bordnetzspannung nicht weiter absinken zu lassen. Zu dieser Vorsichtsmaßnahme zählt das Abschalten von diversen Verbrauchern mit hohem Stromverbrauch, wie z. B. der Klimaanlage, da eine im Fahrzeug installierte Klimaanlage für einen sicherheitsrelevanten Betrieb nicht unbedingt eingeschaltet sein muss.

Wenn die Batteriekapazität weniger als 9 V beträgt, werden alle nicht sicherheitsrelevanten Stromverbraucher abgeschaltet, um die Funktion der elektronischen Parkbremse zu gewährleisten, bis ein Batterieaustausch erfolgt. Weitere verschiedene zyklische Überprüfungen der Fahrzeugbatterie sowie sich an der aktuellen Batteriekapazität orientierende Maßnahmen werden durchgeführt.

Bei einer weiteren bevorzugten Ausführungsform wird die im Fahrzeug vorhandene Heckscheibenheizung als elektrische Last eingesetzt. Das Steuergerät, das für die Heckscheibenheizung zuständig ist, schaltet die Heckscheibenheizung kurzfristig ein, ohne dass dies vom Fahrzeugführer bemerkt wird. Während die Heckscheibeneinheizung eingeschaltet ist, wird vom Steuergerät der elektrischen Parkbremse die Batteriekapazität überprüft. Das Ergebnis der Überprüfung, der aktuell vorhandene Bordnetzspannungswert, wird über den CAN-Bus dem für das Armaturenbrett zuständige Steuergerät Kombi-ECU mitgeteilt. Falls sich der Spannungswert in keinem kritischen Zustand befindet, d.h. der Bordnetzspannungswert beträgt 12 V oder mehr, ist keine weitere Maßnahme wie eine gesonderte Benachrichtigung des Fahrzeugführers notwendig, da es sich hierbei um den voll funktionsfähigen Zustand der Fahrzeugbatterie handelt. Der vordefinierten Meßzyklus im 10-Sekundentakt wird weiter beibehalten. Da es sich bei dem gemessenen Bordnetzspannungswert um den üblicherweise zu erwarteten Bordnetzspannungswert handelt, wird dies durch eine optische Anzeige z.B. in grün angezeigt. Bei Absinken der Bordnetzspannung werden nacheinander orange und rote Wamanzeigen verwendet.

Bei einer anderen Ausgestaltung des erfindungsgemäßen Verfahrens wird kurzfristig das Navigationssystem des Fahrzeugs durch dessen Steuergerät als elektrische Last eingeschaltet, wenn sich diese Komponente zum Zeitpunkt der Überprüfung nicht in Betrieb befindet. Um den Fahrzeugführer nicht zu irritieren, ertönt eine optische Mitteilung, dass es sich um einen kurzen Test handelt, der die Fahrfunktionen nicht beeinträchtigt. Das EPB-ECU führt die Überprüfung der Bordnetzspannung durch und meldet das Ergebnis an das Steuergerät des Armaturenbretts. Sollte der gemessene Spannungswert z.B. 9,5 Volt betragen, erhält das EPB-ECU die Mitteilung, dass weitere zyklische Messungen im 2-Minuten-Abstand durchgeführt werden sollen (Fig.3). Da es sich bei diesem Spannungswert bereits um einen ernst zu nehmenden Bordnetzspannungswert handelt, erhalten auch die Steuergeräte der Stromverbraucher, die für ein voll funktionsfähiges, sicheres Fahrvermögen des Fahrzeugs nicht unbedingt notwendig sind, über den CAN-Bus die Information, ein mögliches Ausschalten der ihnen zugeordneten Vorrichtungen zu prüfen. Falls die Funktion der Klimaanlage aufgrund der gemessenen Außentemperatur als nicht unbedingt notwendig eingeordnet wird, wird diese zur Schonung der Bordnetzspannung als erste Maßnahme vorerst abgeschaltet. Um den Fahrzeugführer auf die vorhandene kritische Situation hinzuweisen, ertönt außerdem ein akustisches Signal mit einer gleichzeitigen Warnanzeige durch eine orange LED im Armaturenbrett und ein Hinweis im Navigationssystem, dass der Bordnetzspannungswert 9,5 V beträgt und nicht sicherheitsrelevante Stromverbraucher vom Fahrzeugführer abgeschalten werden sollen und eine Überprüfung der Batterie beim nächsten Fahrzeugstop durchgeführt werden soll.

In einem weiteren Ausführungsbeispiel wird die Sitzheizung als elektrische Last durch deren Steuergerät eingeschaltet und das EPB-ECU übernimmt die Prüfung der Fahrzeugbatterie. Falls bei diesem Ausführungsbeispiel die Überprüfung der Spannung ergibt, dass sich die aktuelle Batteriekapazität bereits unterhalb eines Wertes von z.B. 8 V befindet, müssen sofortige Maßnahmen ergriffen werden. Die Meldung des nicht mehr akzeptablen Bordnetzspannungswertes erfolgt wiederum direkt an das Steuergerät, welches die Daten zur Information des Fahrzeugführers weiterverarbeitet. Bei diesem Beispiel wird das Steuergerät des Navigationssystems im Fahrzeug zum Informieren des Fahrzeugführers eingesetzt und eine Meldung erfolgt sowohl optisch durch eine rot blinkende LED als auch mit Schriftzug im Navigationssystem. Eine akustische Meldung erfolgt mit dem Hinweis, beim nächsten Fahrzeugstop darauf zu achten, dass die Sicherheit der elektrischen Parkbremse nicht mehr gewährleistet ist und ein sofortiger Batteriewechsel veranlasst werden muss. Um die vorhandene Bordnetzspannung für den laufenden Betrieb bis zu diesem Zeitpunkt aufrechterhalten zu können, werden alle Steuergeräte der nicht sicherheitsrelevanten Stromverbraucher im Fahrzeug über den CAN-Bus angewiesen, diese auszuschalten bzw. in einen Notbetrieb umzuschalten. Weitere Messungen werden aufgrund des gesamten Notbetriebs nur noch bei ausgeschalteter Zündung durchgeführt. Zusätzlich erfolgt bei dem nächsten Fahrzeugstop nochmals dieselbe Meldung an den Fahrzeugführer mit dem Hinweis, zusätzliche Maßnahmen wie das Abstellen des Fahrzeugs auf einem ebenen Gelände durchzuführen.

Die Erfindung kann zur Früherkennung eines möglichen Ausfalles eines elektrisch gesteuerten Bremssystems verwendet werden, jedoch könnte das Verfahren auch bei anderen sicherheitsrelevanten Komponenten im Fahrzeug eingesetzt werden, für die eine laufende Überwachung der vorhandenen Batteriespannung zur Verhinderung eines Ausfalles notwendig ist.

## Patentansprüche

1. Verfahren zur Früherkennung eines möglichen Ausfalls eines elektrisch gesteuerten Bremssystems mittels Überprüfens einer Bordnetzspannung (U_{Bat}), wobei die Bordnetzspannung von einer Fahrzeugbatterie bereitgestellt wird und zum Überprüfen der Bordnetzspannung eine elektrische Last mittels eines dieser Last zugeordneten ersten Steuergerätes eingeschaltet wird, **dadurch gekennzeichnet, dass** zum Überprüfen der Bordnetzspannung ferner:
- im eingeschalteten Zustand der Last ein Überprüfen der Fahrzeugbatterie mittels eines zweiten Steuergerätes erfolgt; und
- das Ergebnis der Überprüfung zur Früherkennung eines möglichen Ausfalls des elektrisch gesteuerten Bremssystems verwendet wird.

2. Verfahren gemäß Anspruch 1, **dadurch gekennzeichnet, dass** es sich bei dem zweiten Steuergerät um ein Steuergerät des elektrisch gesteuerten Bremssystems handelt.

3. Verfahren gemäß einem der Ansprüche 1 und 2, **dadurch gekennzeichnet, dass** eine Kommunikation zwischen den Steuergeräten über einen Fahrzeug-Bus erfolgt.

4. Verfahren gemäß einem der Ansprüche 1 bis 3, **dadurch gekennzeichnet, dass** es sich bei dem Ergebnis der Überprüfung um den gemessenen Bordnetzspannungswert handelt.

5. Verfahren gemäß einem der Ansprüche 1 bis 4, **dadurch gekennzeichnet, dass** einem Fahrzeugführer das Ergebnis der Überprüfung mitgeteilt wird.

6. Verfahren gemäß Anspruch 5, **dadurch gekennzeichnet, dass** das Ergebnis mittels eines optischen Signals im Armaturenbrett und/oder mittels eines akustischen Signals angezeigt wird.

7. Verfahren gemäß einem der Ansprüche 1 bis 6, **dadurch gekennzeichnet, dass** es sich bei der elektrischen Last um eine Klimaanlage, eine beheizbare Heckscheibe oder einen anderen, standardmäßig vorgesehenen Verbraucher handelt.

8. **Verfahren gemäß einem der Ansprüche 1 bis 7, dadurch gekennzeichnet, dass die** Überprüfung des Zustandes der Fahrzeugbatterie mit Hilfe zyklischer Messungen vorgenommen wird.

9. Verfahren gemäß Anspruch 8, **dadurch gekennzeichnet, dass** die zyklischen Messungen in Abhängigkeit von einer aktuellen Batteriekapazität vorgenommen werden.

10. Verfahren gemäß einem der Ansprüche 1 bis 9, **dadurch gekennzeichnet, dass** in Abhängigkeit von dem Ergebnis eine vordefinierte Maßnahme eingeleitet wird.

11. Verfahren gemäß Anspruch 10, **dadurch gekennzeichnet, dass** es sich bei der Maßnahme um ein Abschalten von Stromverbrauchern handelt.

12. System zum Durchführen des Verfahrens nach einem der vorhergehenden Ansprüche zur Früherkennung eines möglichen Ausfalls eines elektrisch gesteuerten Bremssystems mittels Überprüfens einer Bordnetzspannung (U_{Bat}), wobei das System das elektrisch gesteuerte Bremssystem, eine Fahrzeugbatterie, welche die Bordnetzspannung (U_{Bat}) bereitstellt, und eine durch ein erstes Steuergerät eingeschaltete elektrische Last umfasst, **dadurch gekennzeichnet, dass** das System weiterhin ein zweites Steuergerät zum Überprüfen der Bordnetzspannung (U_{Bat}) der Fahrzeugzeugbatterie bei eingeschalteter Last umfasst und das Ergebnis der Überprüfung der Bordnetzspannung (U_{Bat}) zur Früherkennung eines möglichen Ausfalls des elektrisch gesteuerten Bremssystems verwendet.

## Claims

1. A method for the early recognition of a possible failure of an electrically controlled brake system by means of checking of an onboard power-supply voltage (U_{Bat}), the onboard power-supply voltage being provided by a vehicle battery and, for the purpose of checking the onboard power-supply voltage, an electrical load being switched on by means of a first controller assigned to this load, **characterized in that**, for the purpose of checking the onboard power-supply voltage, also
- checking of the vehicle battery is effected by means of a second controller, with the load in the switched-on state; and
- the result of the checking is used for the early recognition of a possible failure of the electrically controlled brake system.

2. The method according to Claim 1, **characterized in that** the second controller is a controller of the electrically controlled brake system.

3. The method according to any one of Claims 1 and 2, **characterized in that** communication between the controllers is effected via a vehicle bus.

4. The method according to any one of Claims 1 to 3, **characterized in that** the result of the checking is the measured onboard power-supply voltage value.

5. The method according to any one of Claims 1 to 4, **characterized in that** the result of the checking is communicated to a vehicle driver.

6. The method according to Claim 5, **characterized in that** the result is indicated by means of a visual signal in the instrument panel and/or by means of an acoustic signal.

7. The method according to any one of Claims 1 to 6, **characterized in that** the electrical load is an air-conditioning system, a heatable rear window or another consumer that is provided as standard.

8. The method according to any one of Claims 1 to 7, **characterized in that** the checking of the state of the vehicle battery is effected through the use of cyclic measurements.

9. The method according to Claim 8, **characterized in that** the cyclic measurements are performed in dependence on a current battery capacity.

10. The method according to any one of Claims 1 to 9, **characterized in that** a predefined measure is initiated in dependence on the result.

11. The method according to Claim 10, **characterized in that** the measure is a switching-off of current-consumers.

12. A system for executing the method according to any one of the preceding claims for the early recognition of a possible failure of an electrically controlled brake system by means of checking an onboard power-supply voltage (U_{Bat}), the system comprising the electrically controlled brake system, a vehicle battery providing the onboard power-supply voltage (U_{Bat}), and an electrical load switched on by a first controller, **characterized in that** the system further comprises a second controller for checking the onboard power-supply voltage (U_{Bat}) of the vehicle battery, with the load in the switched-on state, and the result of the checking of the onboard power-supply voltage (U_{Bat}) is used for the early recognition of a possible failure of the electrically controlled brake system.

## Revendications

1. Procédé permettant la détection précoce, au moyen de la vérification d'une tension de réseau de bord (U_{Bat}), d'un dysfonctionnement possible d'un système de freinage à commande électrique, ladite tension de réseau de bord étant fournie par une batterie du véhicule et une charge électrique étant mise sous tension par un premier dispositif de commande associé à cette charge pour vérifier la tension de réseau de bord, **caractérisé en ce que**, pour ladite vérification de la tension de réseau de bord,
- il est, dans cet état de charge sous tension, effectué une vérification de la batterie du véhicule au moyen d'un second dispositif de commande ; et
- il est utilisé le résultat de la vérification pour la détection précoce d'un dysfonctionnement possible du système de freinage à commande électrique.

2. Procédé selon la revendication 1, **caractérisé en ce que** le second dispositif de commande consiste en un dispositif de commande du système de freinage à commande électrique.

3. Procédé selon l'une des revendications 1 et 2, **caractérisé en ce que** la communication entre les dispositifs de commande est assurée par un bus installé dans le véhicule.

4. Procédé selon l'une des revendications 1 à 3, **caractérisé en ce que** le résultat de la vérification consiste en la valeur correspondant à la tension de réseau de bord mesurée.

5. Procédé selon l'une des revendications 1 à 4, **caractérisé en ce que** le résultat de la vérification est communiqué au conducteur du véhicule.

6. Procédé selon la revendication 5, **caractérisé en ce que** le résultat est indiqué à l'aide d'un signal optique s'affichant sur le tableau de bord et/ou à l'aide d'un signal acoustique.

7. Procédé selon l'une des revendications 1 à 6, **caractérisé en ce que** la charge électrique consiste en un climatiseur, une lunette arrière chauffante ou un autre utilisateur prévu de manière standard.

8. Procédé selon l'une des revendications 1 à 7, **caractérisé en ce que** la vérification de l'état de la batterie du véhicule est effectuée au moyen de mesures cycliques.

9. Procédé selon la revendication 8, **caractérisé en ce que** les mesures cycliques sont effectuées en fonction d'une capacité de batterie actuelle.

10. Procédé selon l'une des revendications 1 à 9, **caractérisé en ce qu'**une mesure prédéfinie est mise en oeuvre en fonction du résultat obtenu.

11. Procédé selon la revendication 10, **caractérisé en ce que** ladite mesure consiste en une mise hors tension d'utilisateurs.

12. Système permettant la réalisation du procédé selon l'une des revendications précédentes destiné à la détection précoce, au moyen de la vérification d'une tension de réseau de bord (U_{Bat}), d'un dysfonctionnement possible d'un système de freinage à commande électrique ledit système comprenant le système de freinage à commande électrique, une batterie de véhicule fournissant la tension de réseau de bord (U_{Bat}) et une charge électrique mise sous tension par un premier dispositif de commande, **caractérisé en ce que** le système comprend également un second dispositif de commande pour vérifier la tension de réseau de bord (U_{Bat}) fournie par la batterie du véhicule en présence d'une charge sous tension, et que le résultat de la vérification de la tension de réseau de bord (U_{Bat}) est utilisé pour la détection précoce d'un dysfonctionnement possible du système de freinage à commande électrique.
